# EUROPEAN PATENT SPECIFICATION

(11) **EP 1 372 039 B1**
(45) Date of publication and mention of the grant of the patent: **14.11.2007**
(21) Application number: 03253696.3
(22) Date of filing: 11.06.2003
(51) Int. Cl.: G03F 7/20

(54) **Lithographic apparatus and device manufacturing method**
Lithographischer Apparat und Verfahren zur Herstellung eines Artikels
Appareil lithographique et procédé pour la production d'un dispositif

(30) Priority: 13.06.2002 EP 02254139
(43) Date of publication of application: 17.12.2003
(73) Proprietor: ASML Netherlands B.V., 5504 DR Veldhoven (NL)
(72) Inventor: Vosters, Petrus Matthijs Henricus, 5531 EH Bladel (NL); Jacobs, Hernes, 5627 CJ Eindhoven (NL); Van der Schoot, Harmen Klaas, 5265 RK Vught (NL); Rutgers, Peter, 7556 BW Hengelo (OV) (NL)
(74) Representative: Leeming, John Gerard

(56) References cited:
- EP-A- 1 052 551
- EP-A- 1 052 553
- EP-A- 1 211 562

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate;
- a vacuum chamber enclosing said support structure and/or said substrate table;
- an elongate through-slot in a wall of said vacuum chamber; and
- a linear seal sealing said vacuum chamber along said slot.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating pbase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant. McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

In a lithographic apparatus, the size of features that can be imaged onto the substrate is limited by the wavelength of the projection radiation. To produce integrated circuits with a higher density of devices and hence higher operating speeds, it is desirable to be able to image smaller features. Whilst most current lithographic projection apparatus employ ultraviolet light generated by mercury lamps or excimer lasers, it has been proposed to use shorter wavelength radiation of around 13nm. Such radiation is termed extreme ultraviolet (EUV) or soft x-ray, and possible sources include laser produced plasma sources and discharge plasma sources.

Other proposed radiation types include electron beams and ion beams. Further information with regard to the use of electron beams in lithography can be gleaned, for example, from US 5,079,122 and US 5,260,151, as well as from EP-A-0 965 888. These types of beam share with EUV the requirement that the beam path, including the mask, substrate and optical components, be kept in a high vacuum. This is to prevent absorption and/or scattering of the beam, whereby a total pressure of less than about 10⁻⁶ millibar is typically necessary for charged particle beams. Otherwise, for apparatus using EUV radiation, the total vacuum pressure need only be between 10⁻⁵ and 10⁻⁷ millibar H₂O and between 10⁻⁷ and 10⁻⁹ millibar CₓH_{y}. Optical elements for EUV radiation can be spoiled by the deposition of carbon layers on their surface, which imposes the additional requirement that hydrocarbon partial pressures should generally be kept as low as possible, for example below 10⁻⁸ or 10⁻⁹ millibar.

Working in a high vacuum imposes quite onerous conditions on the components that must be put into the vacuum. For components inside the vacuum chamber, materials that minimize or eliminate contaminant and total outgassing, i.e. both outgassing from the materials themselves and from gases adsorbed on their surfaces, should be used. Conventional designs of substrate, mask and transfer stages are very complicated and employ large numbers of sensors and drive arrangements, which all need a large numbers of conduits for conveying water and gases and for protecting electric wiring.

A solution is proposed in EP 1 052 549-A. This publication describes conduits that are fed through hollow pipes that are rigidly connected to a movable object table. The pipes are used to transfer movements from outside a vacuum chamber to the table. The pipes are hollow and the pressure within the pipes is equal to the pressure outside the vacuum chamber. The pipes pass through an elongate slot in a wall of the vacuum chamber and are movable in the elongate direction of that slot. A seal is maintained over that slot by a sliding seal plate through which the pipe extends and which is also displaceable in the elongate direction of the slot. Thus, many components can be left outside of the vacuum. A problem with this arrangement is the high inertia of the sliding seal plate as well as the need for air bearings around the outside of the plate to minimize friction and resulting wear from movement of the sliding seal plate against the vacuum chamber wall. The air bearings increase the complexity, bulk and weight of the assembly.

It is an object of the present invention to provide a lithographic projection apparatus in which problems caused by high inertia, large size and complexity of linear moving seals are avoided or alleviated.

This and other objects are achieved according to the invention in a lithographic apparatus as specified in the opening paragraph, characterized in that said linear seal comprises an elongate sealing member for sealing said vacuum chamber along said slot, said sealing member being locally displacable at a selectable position to provide an opening into said vacuum chamber.

In this way no relative sliding displacement between the elongate sealing member and the wall of the vacuum chamber is present during movement of the selectable position along the slot and thus the need for air bearings is avoided. In fact, as the selectable position moves along the slot the elongate sealing member can be arranged to simply lift off the slot (or to one side). In the case of the sealing member lifting to one side, any friction between the elongate sealing member and the vacuum chamber wall is confined to the local selectable position rather than to the whole of the elongate sealing member. Furthermore, the energy required to move the selectable position along the slot is low as only a small part of the elongate sealing member needs to be moved - namely the material of the elongate sealing member at the selectable position.

Preferably a conduit for providing utilities to said support structure and/or substrate table in said vacuum chamber passes through said slot at said selectable position.

The term utilities as here employed refers to the fluids (e.g. water, gas) electricity and signals that must be provided to the moveable component (i.e. support structure or substrate table). The term conduit refers to the cables and tubes that are used to transport the utilities to the moveable component. By way of example, such conduits may include power cords, signal carriers, gas hoses (e.g. for supplying gas to a gas bearing in the table), coolant hoses, etc. Moveable components inside the vacuum chamber including the mask table and/or the substrate table and/or associated motors and/or sensors may be connected to a frame outside the vacuum chamber in this manner (using a distinct conduit for each component).

If the moveable component is moveable in two dimensions then, as the selectable position has one degree of freedom, the conduit itself only requires one degree of tieedom (namely in the direction substantially normal to the elongate direction of the slot to accommodate movement of the moveable component).

Preferably the elongate sealing member is comprised of a metallic material. In this way, out-gassing of the elongate sealing member may be minimized.

According to another aspect of the present invention, there is provided a lithographic projection apparatus comprising:
a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate;
- a vacuum chamber enclosing said support structure and/or said substrate table;
- an elongate through-slot in a wall of said vacuum chamber; and a linear seal sealing said vacuum chamber along said slot;
characterized in that said linear seal comprises a rotatable sealing band sealing against said slot.

According to a further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of
- radiation-sensitive material;
- providing a vacuum chamber around said substrate and/or said pattering means;
- providing an elongate through slot in a wall of said vacuum chamber;
- using positioning means for positioning said substrate or said pattening means in said vacuum chamber; and
- sealing said vacuum chamber along said slot using a linear seal;
characterized in that said linear seal comprises an elongate sealing member for sealing said vacuum chamber along said slot and by the step of locally displacing said elongate sealing member at a selectable position to provide an opening into said vacuum chamber.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g*, with a wavelength of 365, 248, 193, 157 or 126 nm) and EUV (extreme ultra-violet radiation, e.g. having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 depicts a perspective view of a linear seal according to the present invention in which the housing is cut away to reveal internal components;
Figure 3 depicts a plan view of a wafer stage and linear seal according to the present invention;
Figure 4 depicts a longitudinal cross-sectional view of a linear seal of a second embodiment;
Figure 5 depicts a longitudinal cross-sectional view of a linear seal of a third embodiment; and
Figure 6 depicts a longitudinal cross-sectional view of a linear seal of a fourth embodiment.

In the Figures, corresponding reference symbols indicate corresponding parts.

### Embodiment 1

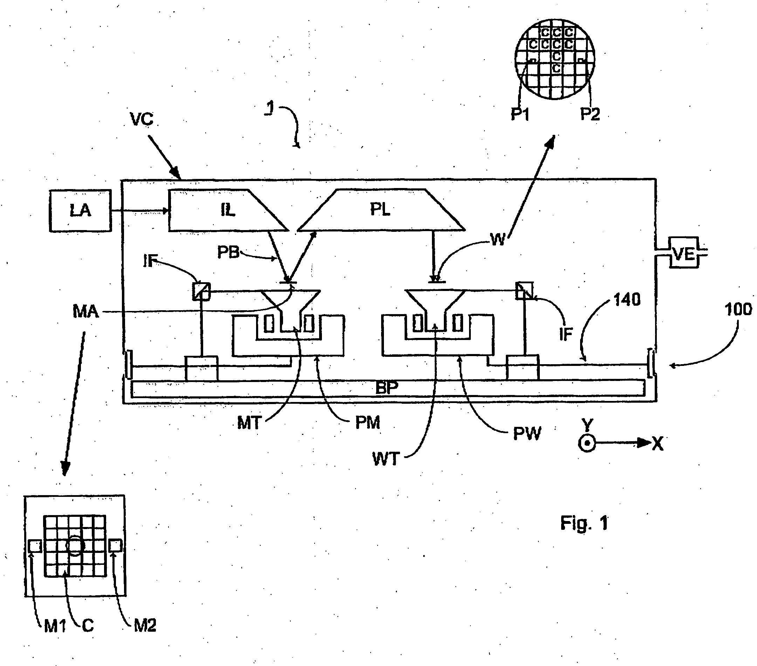

Figure 1 schematically depicts a lithographic projection apparatus according to a particular embodiment of the invention. The apparatus comprises:
· a radiation system Ex, IL, for supplying a projection beam PB of radiation (*e.g.* EUV radiation), which in this particular case also comprises a radiation source LA;
· a first object table (mask table) MT provided with a mask holder for holding a mask MA (*e.g.* a reticle), and connected to first positioning means for accurately positioning the mask with respect to item PL;
· a second object table (substrate table) WT provided with a substrate holder for holding a substrate W (*e.g.* a resist-coated silicon wafer), and connected to second positioning means for accurately positioning the substrate with respect to item PL;
· a projection system ("lens") PL (*e.g.* a mirror group) for imaging an irradiated portion of the mask MA onto a target portion C (*e.g.* comprising one or more dies) of the substrate W.
As here depicted, the apparatus is of a reflective type (*i.e.* has a reflective mask). However, in general, it may also be of a transmissive type, for example (with a transmissive mask).
Alternatively, the apparatus may employ another kind of patterning means, such as a programmable mirror array of a type as referred to above.

The source LA (*e.g.* a laser-induced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a speed *V* = *Mv*, in which *M* is the magnification of the lens PL (typically, *M* = 1/4 or 1/5). In this manner, a relatively large target portion C can be exposed, without having to compromise on resolution.

In a lithographic projection apparatus according to the present invention, at least one of the first object table MT (support structure for supporting the patterning means, the mask) and the second object table WT (the substrate table) are provided in a vacuum chamber VC. The vacuum inside the vacuum chamber VC is created with the evacuating means VE, for example a pump.

Much equipment is associated with an object table, such as alignment sensors, air bearings with differential vacuum seals, positioning motors and actuators which require utilities such as power, control signals, vacuum and gases and supply utilities such as measurement signals and further control signals. These utilities are supplied by conduits 140 such as, for example, hoses, pipes, electric cables etc. which pass into the vacuum chamber VC through an opening in a linear seal 100 in a wall 110 of the vacuum chamber VC. Although the linear seal 100 of the present invention is described in relation to a single substrate table WT or mask table MT, the invention is equally applicable to a so called dual stage lithographic projection apparatus which has two substrate tables each with a substrate holder for holding a substrate W and each connected to a positioning means for positioning of the substrate W. In this case each substrate table would have an associated linear seal. The substrate table(s) is positioned on a base plate BP.

The first and second object tables MT, WT are often required to move in two degrees of freedom. Thus, the utilities which are provided from outside of the vacuum chamber VC to the object tables MT, WT must be provided through conduits 140 with the same number of degrees of freedom. In the present invention this is achieved by providing the conduits 140 inside the vacuum chamber VC with one degree of freedom and by allowing the end of the conduits 140 a second degree of freedom as they pass through a wall 110 of the vacuum chamber. This second degree of freedom is provided by linear seal 100.

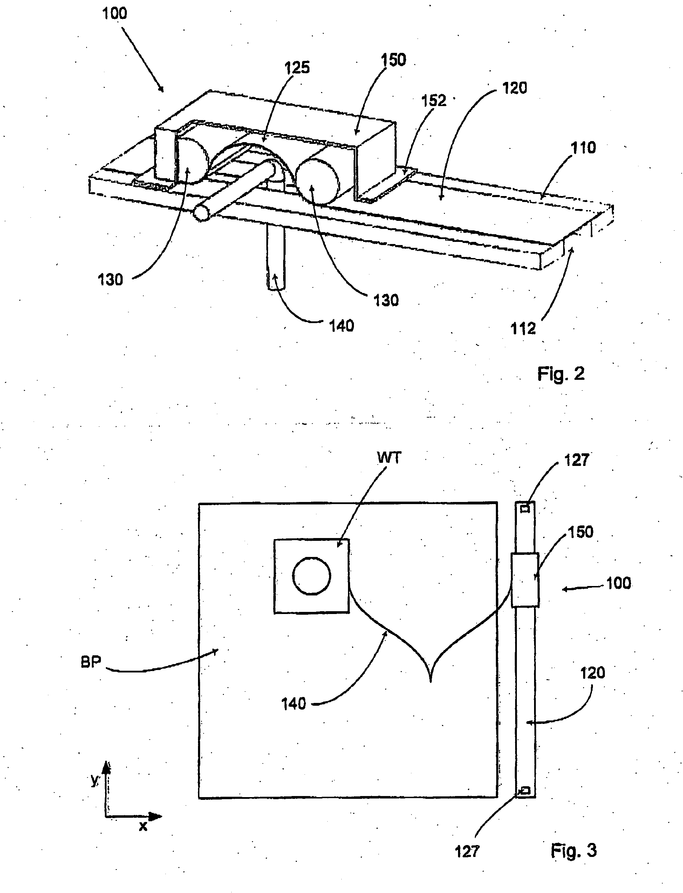

The linear seal 100 of the present invention is illustrated in Figure 2. The linear seal 100 seals over an elongate slot 112 in a wall 110 of the vacuum chamber VC. The linear seal 100 comprises a elongate sealing member 120 which is positined over the elongate slot 112 in the wall 110 of the vacuum chamber VC. The elongate sealing member 120 is locally displaced away from the slot 112 at a selectable position 125 to form the opening into the vacuum chamber from outside.

If the elongate sealing member 120 is formed of a flexible material (for example a thin sheet of metal), it can be locally displaced at the selectable position 125 by bending in an inverted U shape. The preferred material of the elongate sealing member 120 is a metal, preferably one which has ferromagnetic properties, for example, stainless steel about 0.1 mm thick. Such a material has the advantage over rubber or a plastics material in that it does not outgas. The position 125 at which the elongate sealing member 120 is bent in an inverted U shape away from the slot 112 in a direction substantially orthogonal to the surface of the wall 110 is selectable; the portion locally displaced from the slot can be changed by movement of the bent portion along the elongate sealing member 120. It will be appreciated that the bent portion "moves" in the same way as a transverse wave in a taught string by lateral rather than longitudinal movement of parts of the sealing member. Conduits 140 may pass through the opening in the linear seal 100 at the selectable position 125 at which the elongate slot 112 is not sealed by the elongate member 120. Thus, the conduits 140 may pass from outside of the vacuum chamber VC (below the linear seal 100 as illustrated in Figure 2) to inside of the vacuum chamber VC (above the linear seal as illustrated). In this way the end of the conduits 140 are provided with one degree of freedom in the vacuum chamber VC.

In the illustrated embodiment, the elongate sealing member 120 bends at the selected position 125 in a direction orthogonal to the plane of the vacuum chamber wall 110. In fact, if an elongate sealing member 120 with a square (rather than rectangular) cross section perpendicular to the elongate direction and made of a very compliant material is used, the bend of the selectable portion may be displaced from the slot 112 in a direction substantially parallel to the plane of the vacuum chamber wall 110.

In the preferred embodiment rollers 130 are provided on either side of the selectable position 125 to bend the elongate sealing member 120 locally away from the slot 112 to form the opening such that the conduit 140 may enter the vacuum chamber VC through the slot under the bend (i.e. the opening). Other means of bending the elongate sealing member 120 are also possible but the advantage of rollers 130, which are in rolling contact with the elongate sealing member 120, is that friction when the assembly moves to select a different position 125 is reduced.

A frame member (not illustrated) attached between the conduit 140 and the rollers 130 may be conveniently used to transfer a force applied to the conduit outside of the vacuum chamber VC, to the rollers 130. In this way the reaction force (upwards as illustrated) of the elongate sealing member 120 due to it being bent is countered by the rollers 130 which can have a (downwards as illustrated) force applied to them by the conduit 140. Thus, the bend in the elongate sealing member 120 may be contained between the rollers 130 and the remainder of the sealing member 120 can be maintained flat. Selection of the position 125 at which the elongate sealing member 120 is locally displaced from the slot 112 is then made possible by actuation of the conduit 140 along the elongate direction of the slot 112. Magnets (not illustrated) may be provided along the edge of the slot 112 in the vacuum chamber VC wall 110 to attract the elongate sealing member 120 (if made of a ferromagnetic material) along sealing portions to form a better seal.

In the embodiment illustrated in Figure 2, the vacuum chamber VC is at about 10⁻⁷ millibar H₂O provided above the elongate sealing member as illustrated and a lower vacuum of about 10⁻³ millibar is provided underneath the elongate sealing member 120 as illustrated. A vacuum must be provided on each side of the sealing member such that the force of the low vacuum on the sealing member 120 does not push the sealing member 120 away from the vacuum chamber wall 110 into the vacuum chamber VC and to avoid severe leakage into the high vacuum through the seal. If the high vacuum is positioned underneath the elongate sealing member 120 as illustrated in Figure 2, the requirement for vacuum on the other side of the elongate sealing member 120 is no longer present as the higher pressure outside of the vacuum chamber VC will act only to push the elongate sealing member 120 against the wall 110 to create a better seal.

The linear seal comprises a further sealing member which may also be attached to the frame member, which seals the vacuum chamber around the slot 112 at the selected position 125. In the illustrated embodiment this is provided by a housing 150 which is placed over the rollers 130 and through which the conduit 140 extends. A bottom flange 152 of the housing is positioned close to the elongate sealing member 120 and the wall 110 of the vacuum chamber VC to provide a seal. The separation of the housing 150 from the elongate sealing member 120 and the wall 110 is less than 0.1 mm. Either the flange 152 of the housing 150 comprises a recess in which the elongate sealing member 120 is positionable or the sealing member 120 is recessed into the wall of the vacuum chamber 110 by provision of a recess in the wall 110 at the edge of the elongate slot 112. If required, air bearings may be provided around the flange 152.

Although the further sealing member is described as a housing 150, it is also possible that the further sealing member is positioned on the other side of the elongate sealing member 120 and comprises either a housing or a member which extends underneath the bend in the selectable position 125. In that case close positioning to the sealing member 120 in its local position at the opening where it is bent at the selectable position 125 and the edges of the slot 112 is required.

Figure 3 illustrates how the linear seal 100 is used in conjunction with a substrate table WT. The substrate table WT can move in two dimensions on the base plate BP. The conduits 140 extend between the housing 150 of the linear seal 100 and the substrate table WT. When the substrate table WT moves in the Y direction, a corresponding movement in the Y direction of the housing 150 and thereby conduit end occurs. On movement in the Y direction the rollers 130 move in the elongate direction of the elongate slot 112 thereby selecting the position 125 at which the elongate sealing member is locally displaced from the slot 112. When the substrate table WT moves in the X direction the conduits 140 take up that movement by bending. Of course the conduits are illustrated as flexible in Figure 3 though this may not be the case and the conduits may be rigid and movement of the substrate table WT in the X direction may be taken up by mechanical means. For an example of such an arrangement see EP-1 052 549-A.

Figure 3 also illustrates that the elongate sealing member 120 is fixed in close proximity to each end 127. As will be appreciated, the elongate sealing member 120 is longer than the slot 112 and so the distance apart of the fixation points 127 of the elongate member 120 is less than the length of the elongate member 120. This allows the elongate member 120 to bend at the selectable position 125.

Although the elongate sealing member 120 and housing 150 have been illustrated as being positioned in the vacuum chamber VC, it is possible for those elements or even only one of those elements to be situated outside of the vacuum chamber.

### Embodiments 2 and 3

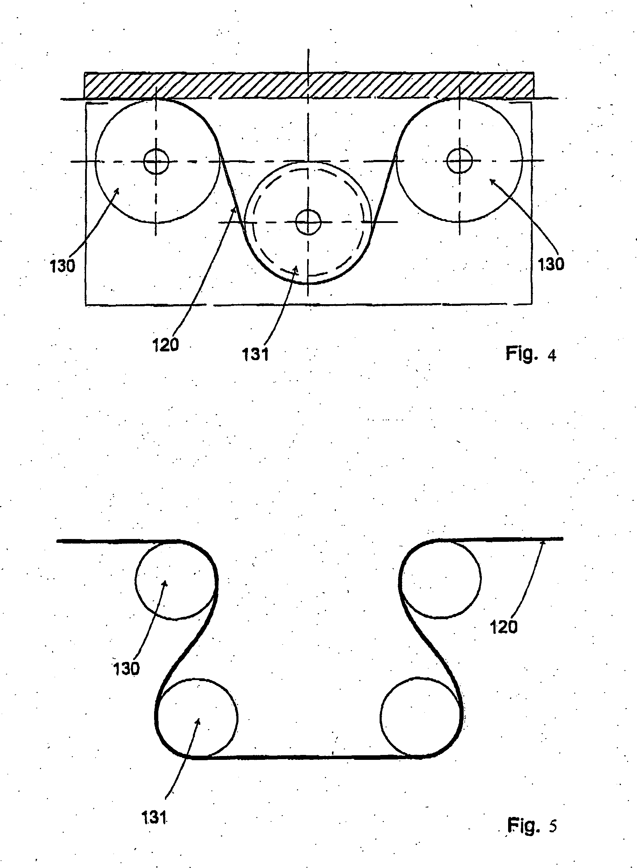

Figures 4 and 5 show the second and third embodiments which are the same as the first embodiment except that one or two (or more) further rollers 131 are used to hold the elongate sealing member 120 away from the slot at the selectable portion 125. This is done by positioning the further rollers 131 on the opposite side of the elongate sealing member to the rollers 130 between the slot 112 and the elongate sealing member 120. The further rollers 131 are in rolling contact with the elongate sealing member 120.

### Embodiment 4

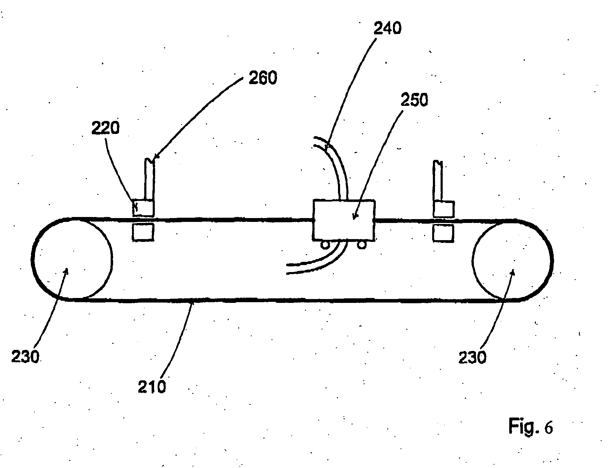

In a fourth embodiment illustrated in Figure 6, an elongate sealing band 210 is used to seal the vacuum chamber VC, The band 210 is supported on and rotated by two rollers 230. A fixed length of band is always inside the vacuum chamber but the part of the band inside the vacuum chamber is altered by rotation of the band 210. A car 250 is attached between portions of the band 210 and is always situated on one side (top side as illustrated) in the vacuum chamber VC and on the other side (bottom side as illustrated) outside of the vacuum chamber VC. The car 250 allows the passage of conduits 240 through it from outside of the vacuum chamber VC to inside of the chamber. By rotation of the rollers 230 and thereby the band 210, the car 250 and so the entry point of the conduits into the vacuum chamber VC is varied in one degree of freedom. Seals 220 between side walls 260 of the vacuum chamber VC and the band 210 (which may be vacuum seals for example) seal all around the portion of band 210 in the chamber (i.e. along both longitudinal edges and across the width at the end of the portions). This system has low inertia and is not too complicated.

Whilst specific embodiments of the invention have been described above, it will be appreciated that the invention may be practiced otherwise than as described. The description is not intended to limit the invention.

## Claims

1. A lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate;
- a vacuum chamber enclosing said support structure and/or said substrate table;
- an elongate through-slot (112) in a wall of said vacuum chamber; and a linear seal (100) sealing said vacuum chamber along said slot;
**characterized in that** said linear seal comprises
an elongate sealing member (120) for sealing said vacuum chamber along said slot, said sealing member being locally displacable at a selectable position to provide an opening into said vacuum chamber.

2. An apparatus according to claim 1, wherein said elongate sealing member is comprised of a metallic material.

3. An apparatus according to claim 1 or 2, wherein said elongate sealing member is bent at said selectable position and substantially flat elsewhere.

4. An apparatus according to any one of the preceding claims, further comprising a conduit for providing utilities to said support structure and/or said substrate table in said vacuum chamber, said conduit passing through said slot and between said wall and said elongate sealing member at said selectable position.

5. An apparatus according to any one of the preceding claims, wherein said linear seal further comprises two rollers one on either side of said selectable position and in rolling contact with said elongate sealing member, said selectable position being selectable by movement of said rollers together.

6. An apparatus according to claim 5, further comprising at least one further roller in rolling contact with said elongate sealing member positioned between said elongate sealing member and said slot at said selectable position.

7. An apparatus according to any one of the preceding claims, wherein said elongate sealing member is comprised of a ferromagnetic material and magnets are positioned along said slot to attract said elongate sealing member towards said slot.

8. An apparatus according to any one of the preceding claims, wherein said linear seal further comprises a further sealing member sealing around said selectable position.

9. An apparatus according to claim 8, wherein said further sealing member comprises a housing positioned over said selectable position and sealing against said wall and said elongate sealing member thereby to seal said slot at said selectable position.

10. A device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material;
- providing a vacuum chamber around said substrate and/or said pattening means;
- providing an elongate through slot in a wall of said vacuum chamber;
- using positioning means for positioning said substrate or said pattening means in said vacuum chamber; and
- sealing said vacuum chamber along said slot using a linear seal;
**characterized in that** said linear seal comprises an elongate sealing member for seating said vacuum chamber along said slot and by the step of locally displacing said elongate sealing member at a selectable position to provide an opening into said vacuum chamber.

11. A lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate;
- a vacuum chamber enclosing said support structure and/or said substrate table;
- an elongate through-slot in a wall of said vacuum chamber; and
a linear seal sealing said vacuum chamber along said slot;
**characterized in that** said linear seal comprises a rotatable sealing band (210) sealing against said slot.

## Patentansprüche

1. Lithographischer Projektionsapparat mit :
- einem Bestrahlungssystem zur Bereitstellung eines Projektionsstrahls der Strahlung ;
- einer Tragkonstruktion zum Halten von Bemusterungsvorrichtungen, wobei die Bemusterungsvorrichtungen dazu dienen, den Projektionsstrahl nach einem gewünschten Muster zu bemustern ;
- einem Substrattisch zum Halten eines Substrates ;
- einem Projektionssystem zum Projizieren des bemusterten Strahls auf einen Zielabschnitt des Substrates ;
- einer Vakuumkammer, die die Tragkonstruktion und/oder den Substrattisch umgibt ;
- einem langen Durchgangsschlitz (112) in einer Wand der Vakuumkammer ; und
- einer linearen Abdichtung (100), mit der die Vakuumkammer entlang dem Schlitz abgedichtet wird ;
**dadurch gekennzeichnet, dass** die lineare Abdichtung folgendes umfasst :
ein langes Abdichtelement (120), um die Vakuumkammer entlang dem Schlitz abzudichten, wobei das Abdichtelement lokal an einer wählbaren Position verschoben werden kann, um eine Öffnung in die Vakuumkammer bereitzustellen.

2. Apparat nach Anspruch 1, wobei das lange Abdichtelement aus einem Metallwerkstoff besteht.

3. Apparat nach Anspruch 1 oder 2, wobei das lange Abdichtelement an einer wählbaren Position gebogen und an anderen Stellen im wesentlichen flach ist.

4. Apparat nach einem der vorhergehenden Ansprüche, der weiterhin eine Versorgungsleitung zu der Tragkonstruktion und/oder zu dem Substrattisch in der Vakuumkammer umfasst, wobei die Versorgungsleitung durch den Schlitz und zwischen der Wand und dem langen Abdichtelement an der wählbaren Position verläuft.

5. Apparat nach einem der vorhergehenden Ansprüche, wobei die lineare Abdichtung weiterhin zwei Rollen - je eine auf einer Seite der wählbaren Position - umfasst, die mit dem langen Abdichtelement in Rollkontakt stehen, wobei die wählbare Position durch gemeinsame Bewegung der Rollen wählbar ist.

6. Apparat nach Anspruch 5, der weiterhin mindestens eine weitere Rolle umfasst, die mit dem langen Abdichtelement, das zwischen dem langen Abdichtelement und dem Schlitz an der wählbaren Position positioniert ist, in Rollkontakt steht.

7. Apparat nach einem der vorhergehenden Ansprüche, wobei das lange Abdichtelement aus einem ferromagnetischen Material besteht, und Magneten entlang dem Schlitz angeordnet sind, um lange Abdichtelemente in Richtung des Schlitzes anzuziehen.

8. Apparat nach einem der vorhergehenden Ansprüche, wobei die lineare Abdichtung weiterhin ein weiteres Abdichtelement umfasst, das um die wählbare Position herum abdichtet.

9. Apparat nach Anspruch 8, wobei das weitere Abdichtelement ein Gehäuse umfasst, das über der wählbaren Position positioniert ist, und gegen die Wand und das lange Abdichtelement abdichtet, um so den Schlitz an der wählbaren Position abzudichten.

10. Herstellungsverfahren für einen Baustein, das folgende Schritte umfasst :
- Bereitstellung eines Substrates, das zumindest teilweise von einer Schicht aus strahlungsempfindlichem Material bedeckt ist ;
- Bereitstellung eines Projektionsstrahls der Strahlung unter Verwendung eines Bestrahlungssystems ;
- Verwendung von Bemusterungsvorrichtungen, um den Projektionsstrahl mit einem Muster in seinem Querschnitt zu versehen ;
- Projektion des bemusterten Projektionsstrahls der Strahlung auf einen Zielabschnitt der Schicht aus strahlungsempfindlichem Material;
- Bereitstellung einer Vakuumkammer um das Substrat und/oder die Bemusterungsvorrichtungen herum ;
- Bereitstellung eines langen Durchgangsschlitzes in einer Wand der Vakuumkammer ;
- Verwendung von Positionierelementen zur Positionierung des Substrates oder der Bemusterungsvorrichtungen in der Vakuumkammer ; und
- Abdichtung der Vakuumkammer entlang dem Schlitz unter Verwendung einer linearen Abdichtung ;
**dadurch gekennzeichnet, dass** die lineare Abdichtung ein langes Abdichtelement zum Abdichten der Vakuumkammer entlang dem Schlitz besitzt, und um mit dem Schritt der lokalen Verschiebung des langen Abdichtelementes an einer wählbaren Position eine Öffnung in die Vakuumkammer bereitzustellen.

11. Lithographischer Projektionsapparat mit:
- einem Bestrahlungssystem zur Bereitstellung eines Projektionsstrahls der Strahlung ;
- einer Tragkonstruktion zum Halten von Bemusterungsvorrichtungen, wobei die Bemusterungsvorrichtungen dazu dienen, den Projektionsstrahl nach einem gewünschten Muster zu bemustern ;
- einem Substrattisch zum Halten eines Substrates ;
- einem Projektionssystem zum Projizieren des bemusterten Strahls auf einen Zielabschnitt des Substrates ;
- einer Vakuumkammer, die die Tragkonstruktion und/oder den Substrattisch umgibt ;
- einem langen Durchgangsschlitz in einer Wand der Vakuumkammer ; und
einer linearen Abdichtung, mit der die Vakuumkammer entlang dem Schlitz abgedichtet wird ;
**dadurch gekennzeichnet, dass** die lineare Abdichtung ein drehbares Dichtungsband (210) zur Abdichtung gegen den Schlitz besitzt.

## Revendications

1. Appareil de projection lithographique comprenant :
- un système de rayonnement pour délivrer un faisceau de projection de rayonnement ;
- une structure de support pour supporter des moyens de mise en forme, les moyens de mise en forme servant à mettre en forme le faisceau de projection conformément à un motif voulu ;
- une table de substrat pour tenir un substrat ;
- un système de projection pour projeter le faisceau mis en forme sur une partie cible du substrat ;
- une chambre à vide renfermant ladite structure de support et/ou ladite table de substrat ;
- une fente traversante allongée (112) dans une paroi de ladite chambre à vide ; et
- un joint linéaire (100) rendant étanche ladite chambre à vide le long de ladite fente ;
**caractérisé en ce que** ledit joint linéaire comprend :
un élément d'étanchéité allongé (120) pour rendre étanche ladite chambre à vide le long de ladite fente, ledit élément d'étanchéité étant déplaçable localement à une position sélectionnable pour fournir une ouverture dans ladite chambre à vide.

2. Appareil selon la revendication 1, dans lequel ledit élément d'étanchéité allongé est constitué d'un matériau métallique.

3. Appareil selon la revendication 1 ou 2, dans lequel ledit élément d'étanchéité allongé est courbé à ladite position sélectionnable et sensiblement plat ailleurs.

4. Appareil selon l'une quelconque des revendications précédentes, comprenant en outre un conduit pour fournir des utilitaires à ladite structure de support et/ou ladite table de substrat dans ladite chambre à vide, ledit conduit passant à travers ladite fente et entre ladite paroi et ledit élément d'étanchéité allongé à ladite position sélectionnable.

5. Appareil selon l'une quelconque des revendications précédentes, dans lequel ledit joint linéaire comprend en outre deux rouleaux, un de chaque côté de ladite position sélectionnable et en contact de roulement avec ledit élément d'étanchéité allongé, ladite position sélectionnable étant sélectionnable par le mouvement desdits rouleaux ensemble.

6. Appareil selon la revendication 5, comprenant en outre au moins un rouleau supplémentaire en contact de roulement avec ledit élément d'étanchéité allongé positionné entre ledit élément d'étanchéité allongé et ladite fente à ladite position sélectionnable.

7. Appareil selon l'une quelconque des revendications précédentes, dans lequel ledit élément d'étanchéité allongé est constitué d'un matériau ferromagnétique et des aimants sont positionnés le long de ladite fente pour attirer ledit élément d'étanchéité allongé en direction de ladite fente.

8. Appareil selon l'une quelconque des revendications précédentes, dans lequel ledit joint linéaire comprend en outre un élément d'étanchéité supplémentaire assurant une étanchéité autour de ladite position sélectionnable.

9. Appareil selon la revendication 8, dans lequel ledit élément d'étanchéité supplémentaire comprend un boîtier positionné sur ladite position sélectionnable et assurant une étanchéité contre ladite paroi et ledit élément d'étanchéité allongé de manière à rendre étanche ladite fente à la position sélectionnable.

10. Procédé de fabrication de dispositif comprenant les étapes consistant à :
- fournir un substrat qui est au moins partiellement recouvert d'une couche de matériau sensible au rayonnement ;
- fournir un faisceau de projection de rayonnement en utilisant un système de rayonnement ;
- utiliser des moyens de mise en forme pour doter le faisceau de projection d'un motif dans sa coupe transversale ;
- projeter le faisceau de rayonnement mis en forme sur une partie cible de la couche de matériau sensible au rayonnement ;
- fournir une chambre à vide autour dudit substrat et/ou desdits moyens de mise en forme ;
- fournir une fente traversante allongée dans une paroi de ladite chambre à vide ;
- utiliser des moyens de positionnement pour positionner ledit substrat ou lesdits moyens de mise en forme dans ladite chambre à vide ; et
- rendre étanche ladite chambre à vide le long de ladite fente en utilisant un joint linéaire ;
**caractérisé en ce que** ledit joint linéaire comprend un élément d'étanchéité allongé pour rendre étanche ladite chambre à vide le long de ladite fente et par l'étape de déplacement local dudit élément d'étanchéité allongé à une position sélectionnable pour fournir une ouverture dans ladite chambre à vide.

11. Appareil de projection lithographique comprenant :
- un système de rayonnement pour délivrer un faisceau de projection de rayonnement ;
- une structure de support pour supporter des moyens de mise en forme, les moyens de mise en forme servant à mettre en forme le faisceau de projection conformément à un motif voulu ;
- une table de substrat pour tenir un substrat ;
- un système de projection pour projeter le faisceau mis en forme sur une partie cible du substrat ;
- une chambre à vide renfermant ladite structure de support et/ou ladite table de substrat ;
- une fente traversante allongée dans une paroi de ladite chambre à vide ; et
- un joint linéaire rendant étanche ladite chambre à vide le long de ladite fente ;
**caractérisé en ce que** ledit joint linéaire comprend une bande d'étanchéité rotative (210) réalisant une étanchéité contre ladite fente.
